(19) **Europäisches Patentamt / European Patent Office / Office européen des brevets**

(11) **EP 1 863 078 A2**

(12) # EUROPEAN PATENT APPLICATION

(43) Date of publication:
05.12.2007 Bulletin 2007/49

(51) Int Cl.:
*H01L 21/66* [(2006.01)]

(21) Application number: 07106417.4

(22) Date of filing: 18.04.2007

(84) Designated Contracting States:
AT BE BG CH CY CZ DE DK EE ES FI FR GB GR HU IE IS IT LI LT LU LV MC MT NL PL PT RO SE SI SK TR
Designated Extension States:
AL BA HR MK YU

(30) Priority: 20.04.2006 US 793565 P
02.04.2007 US 732048

(71) Applicant: **Solid State Measurements, Inc.**
**Pittsburgh, PA 15275 (US)**

(72) Inventor: **Hillard, Robert J.**
**Avalon, Pennsylvania PA 15202 (US)**

(74) Representative: **Hutter, Jacobus Johannes**
**Nederlandsch Octrooibureau**
**P.O. Box 29720**
**2502 LS Den Haag (NL)**

(54) **Method for determining the electrically active dopant density profile in ultra-shallow junction (USJ) structures**

(57)     In a method of determining that a semiconductor wafer or sample has a desirable density of electrically active dopant, minimum and maximum capacitances associated with the semiconducting material forming the wafer or sample at a first point adjacent a topside thereof are determined and minimum and maximum capacitances associated with the semiconducting material forming the wafer or sample at a second point adjacent a beveled surface thereof that is defined by the removal of a portion of the topside thereabove are determined. As a function of the minimum and maximum capacitances determined at each point and the depth on or from the topside surface where each point resides, the electrically active dopant density of the semiconductor wafer or sample can be determined.

FIG. 1

FIG. 2

EP 1 863 078 A2

**Description**

CROSS REFERENCE TO RELATED APPLICATIONS

The present invention claims priority from United States Provisional Patent Application No. 60/793,565, filed on April 20, 2006, the contents of which are incorporated herein by reference.

BACKGROUND OF THE INVENTION

<u>Field of the Invention</u>
The present invention relates to testing of a semiconductor wafer or sample prior to forming one or more integrated circuits thereon and, more particularly, to determining whether the density of electrically active dopant at or near top surfaces of the wafer or sample is within acceptable tolerances prior to forming the one or more integrated circuits thereon.

<u>Description of Related Art</u>
In a semiconductor wafer or sample used to form integrated circuits, the dopant density ($N_{SURF}$) as a function of depth into the semiconducting material of the semiconductor wafer or sample is critical to the operation of integrated circuits formed therefrom. In conventional semiconductor fabrication, dopant ions having a suitable charge (positive or negative) are introduced into the top surface of the semiconductor wafer or sample by any suitable and/or desirable means, such as, without limitation, diffusion, ion implantation, etc.
Prior to forming integrated circuits out of a semiconductor wafer or sample having its top surface doped with ions, it is desirable to determine if the semiconductor wafer or sample has been doped within acceptable tolerances. One such measurement of the efficacy of the ion doping of a semiconductor wafer or sample is the measurement of dopant density as a function of depth of carriers into the semiconducting material of the semiconductor wafer or sample. Heretofore, such measurement involved taking a number of CV-type measurements on the top surface of the semiconductor wafer or sample in a manner known in the art and then converting said measurements into an estimate of dopant density versus depth in the top surface of the semiconductor wafer or sample.
A typical CV-type measurement involves pressing a contact to a top surface of a semiconductor wafer or sample, where the top surface is either the top surface of the semiconducting material of the semiconductor wafer or sample or a top surface of a dielectric overlaying the semiconducting material, superimposing an AC signal on a DC signal imposed on the contact, and sweeping the DC voltage from a first, starting voltage to a second, ending voltage while measuring the capacitance during the sweep.
A problem with the prior art method of determining dopant density in a semiconductor wafer or sample is that such determination is an estimate and, therefore, has a potentially wider margin of error than is desirable. Accordingly, it would be desirable to overcome this problem and others by providing a method and apparatus for determining dopant density more accurately than the prior art techniques.

SUMMARY OF THE INVENTION

The invention is a method of determining that a semiconductor wafer or sample has a desirable density of electrically active dopant. The method includes (a) providing a semiconductor wafer or sample having on a first side thereof a topside and a beveled surface positioned at an acute angle with respect to an imaginary extension of the topside above the beveled surface and on a second, opposite side thereof a backside, the intersection of the topside and the beveled surface defining a bevel edge; (b) positioning the semiconductor wafer or sample between a chuck and a contact with the backside of the semiconductor wafer or sample resting on the chuck; (c) causing the contact to press into contact with the topside and the beveled surface at a plurality of discrete points that run transverse to the bevel edge; (d) at each point in step (c), determining minimum and maximum capacitances of a capacitor formed when the contact is pressed into contact with the topside or the beveled surface; (e) determining as a function of the minimum and maximum capacitances determined for each point in step (d), a density of electrically active dopant in the semiconductor wafer or sample adjacent said point; and (f) determining that the electrically active dopant density of the semiconductor wafer or sample is within a predetermined tolerance based on a comparison of a first relationship of electrically active dopant densities determined in step (e) versus depths from the topside to a second relationship of electrically active dopant densities versus depths determined theoretically or empirically from a reference semiconductor wafer or sample.
In step (f), each relationship can be a plot or curve of electrically active dopant density versus depth from the topside.
The depth of each point on the topside can be zero. The depth of each point on the beveled surface can be the sine of the acute angle times a shortest distance between said point and the bevel edge.

The plurality of points can run perpendicular to the bevel edge.

In step (c), the contact can touch the topside at least one time and can touch the beveled surface at least one time.

The portion of the contact that presses into contact with the topside and the beveled surface can be at least partially spherical.

In step (e), the density of electrically active dopant at each point can be determined from the following equation:

$$C_S = \sqrt{\frac{q^2 K_s \varepsilon_0 N_{SURF}}{2kT\left\{2|U_F| - 1 + \ln\left[1.15\left(|U_F| - 1\right)\right]\right\}}}$$

where

$$C_S = A_c \left[\frac{1}{C_{MIN}} - \frac{1}{C_{MAX}}\right]^{-1};$$

$A_c$ = the contact area between the contact and the corresponding portion of the topside or the beveled surface when the contact is pressed into contact therewith;

$C_{MIN}$ = minimum measured capacitance;

$C_{MAX}$ = maximum measured capacitance;

$$U_F = \frac{q\phi_F}{kT};$$

$$\phi_F = \left(\frac{kT}{q}\right)\ln\left(\frac{N_{SURF}}{n_i}\right);$$

$$n_i = \left(3.87\,e^{16}\right)\left(T^{3/2}\right)^{\left(-E_g - \Delta E_g/2kT\right)};$$

$E_g$ = Energy Gap of the Semiconductor Wafer Substrate (1.124$eV$ at 300°K for Si);

$$\Delta E_g = \left(0.0225eV\right)\left[\frac{N_{SURF}}{10^{18}}\right]^{\frac{1}{2}};$$

$q$ = 1:6021×10$^{19}$ *Coulomb*;

$K_s$ = Dielectric Constant of the Material of the Substrate of the Semiconductor Wafer;

$\varepsilon_0$ = permittivity of free space (8.854×10$^{14}$ *F/cm*);

$k$ = Boltzmann's constant 8.617×10$^{-5}$ *eV/T*; and

$T$ = temperature in degrees Kelvin.

The topside can be either the topside of the semiconducting material of the semiconductor wafer or sample or the topside of a dielectric layer overlaying the semiconducting material of the semiconductor wafer or sample.

The invention is also a method of determining that a semiconductor wafer or sample has a desirable density of electrically active dopant that includes (a) providing a semiconductor wafer or sample having on a first side thereof a topside surface and a beveled surface formed by the removal of a portion of the topside surface thereabove, the beveled surface extending at an acute angle relative to the removed topside surface, the intersection of the topside surface and the beveled surface defining a bevel edge, the semiconductor wafer or sample having on a second, opposite side thereof a backside; (b) determining at each of a plurality of discrete points along the topside surface and the beveled surface minimum and maximum capacitances of a capacitor formed at said point that is comprised of the semiconducting material forming the semiconductor wafer or sample; (c) determining as a function of the minimum and maximum capacitances determined for each point of step (b), a density of electrically active dopant in the semiconductor wafer or sample at or adjacent said point; and (d) determining that the electrically active dopant density of the semiconductor wafer or sample is within a predetermined tolerance based on a comparison of a first relationship of electrically active dopant densities determined in step (c) versus depths from the topside surface to a second relationship of electrically active dopant densities versus depths determined theoretically or empirically from a reference semiconductor wafer or sample.

In step (d), each relationship can be comprised of a set of data points of electrically active dopant density versus depth from the topside surface. Each relationship can be further comprised of a curve fitted to the corresponding set of data points.

The plurality of points can run transverse to the bevel edge. At least one point can be on the topside surface. At least one point can be on the beveled surface. The depth of each point on the topside surface is desirably zero. The depth of each point on the beveled surface is desirably the sine of the acute angle times a shortest distance between said point and the bevel edge.

The minimum and maximum capacitances at each point can be determined via a contact having at least a partially spherical surface pressed into contact with the topside surface or the beveled surface at said point.

The minimum and maximum capacitances at each point can be determined via a CV-type electrical stimulus applied between said at least partially spherical surface and the semiconducting material of the semiconductor wafer or sample.

Lastly, the invention is a method of determining that a semiconductor wafer or sample has a desirable density of electrically active dopant that includes (a) determining minimum and maximum capacitances of a capacitor comprised of the semiconducting material forming a semiconductor wafer or sample at a first point on a topside surface of the semiconductor wafer or sample; (b) determining minimum and maximum capacitances of a capacitor comprised of the semiconducting material forming the semiconductor wafer or sample at a second point on a beveled surface of the semiconductor wafer or sample, the beveled surface being formed by the removal of a portion of the topside surface thereabove; and (c) determining that the electrically active dopant density of the semiconductor wafer or sample is within a predetermined tolerance as a function of the maximum and minimum capacitances determined for each said point and the depth on or from the topside surface where said point resides.

The depth of the first point can be zero. The depth of the second point can be the sine of an acute angle between the beveled surface and the removed topside surface thereabove times a shortest distance between said second point and an intersection of the beveled surface and the topside surface when viewed normal to the topside surface.

Step (c) can further include determining a set of data points of electrically active dopant density versus depth from the topside surface.

The maximum and minimum capacitances at each point can be determined via a contact having at least a partially spherical surface pressed into contact with the surface at said point. The capacitances at each point can be determined via a CV-type electrical stimulus applied between said at least partially spherical surface and the semiconducting material of the semiconductor wafer or sample.

## BRIEF DESCRIPTION OF THE DRAWINGS

Fig. 1 is a combined schematic and block diagram view of a system for testing a semiconductor wafer (shown in cross-section) having a topside and a beveled surface;

Fig. 2 is a view taken along lines II-II in Fig. 1;

Fig. 3 is an exemplary plot of changing capacitance versus changing voltage in response to the application of a CV-type electrical stimulus between a contact and a semiconductor wafer when the contact is pressing against the topside or the beveled surface of the semiconductor wafer; and

Fig. 4 are plots of electrically active dopant density ($N_{SURF}$) versus depth for the semiconductor wafer shown in Fig. 1 and a reference semiconductor wafer.

## DETAILED DESCRIPTION OF THE INVENTION

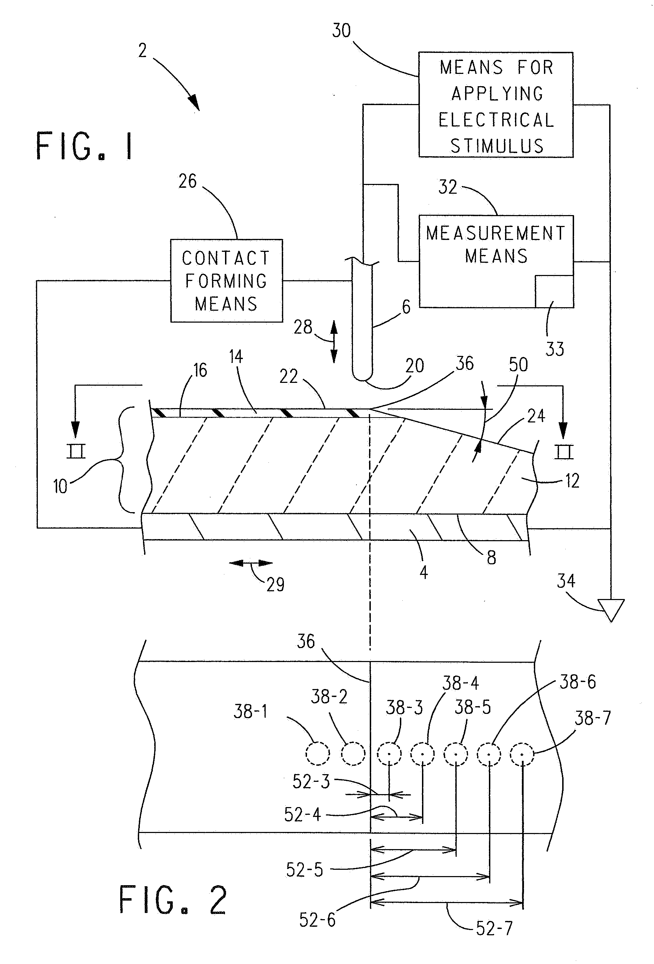

With reference to Fig. 1, a semiconductor wafer or sample test system 2 includes an electrically conductive vacuum chuck 4 and a contact 6. The illustration of contact 6 in the form of an elongated probe, however, is not to be construed as limiting the invention since it is envisioned that contact 6 can have any shape or form suitable for testing a semiconductor wafer or sample 10 under test.

Chuck 4 is configured to support a backside 8 of semiconductor wafer or sample 10 under test, which includes a substrate 12 formed of a semiconducting material, which is held in contact with chuck 4 by means of a vacuum (not shown). As would be appreciated by one skilled in the art of semiconductor wafer or sample processing and testing, substrate 12 of semiconductor wafer or sample 10 can be formed of any suitable semiconducting material known in the art, such as, without limitation, silicon (Si), geranium (Ge), gallium arsenide (GaAs), and the like. Desirably, semiconductor wafer or sample 10 includes a dielectric or oxide layer 14 overlaying a topside of substrate 12.

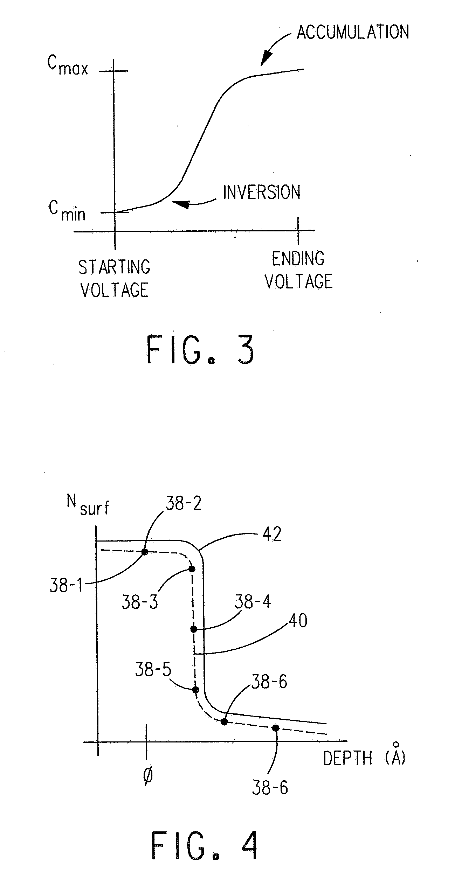

Desirably, contact 6 has at least a partially spherical and conductive surface 20 for contacting a topside 16 of substrate 12, a topside 22 of dielectric layer 14, when present, or a beveled surface 24 (shown in Fig. 2) of substrate 12. While a partially spherical conductive surface 20 is desired, it is envisioned that surfaces (not shown) having other shapes suitable for testing a semiconductor wafer or sample 10 can be utilized. Accordingly, the illustration in Fig. 1 of conductive surface 20 being partially spherical is not to be construed as limiting the invention.

A contact forming means 26, of the type well-known in the art, controls the vertical movement of chuck 4 and/or contact 6, in one or both of the directions shown by arrow 28, to move contact 6 and semiconductor wafer or sample 10 into contact whereupon conductive surface 20 presses into contact with topside 16 of substrate 12, topside 22 of dielectric layer 14, when present, or beveled surface 24 of substrate 12. Also or alternatively, contact forming means 26 can control the horizontal movement of vacuum chuck 4, contact 6, or both in one or both of the directions shown by arrow 29 to enable positioning of conductive surface 20 at desired test locations 38 (shown in Fig. 2) on topside 16 of substrate 12, topside 22 of dielectric layer 14, when present, or beveled surface 24 of substrate 12.

A means for applying electrical stimulus 30 can be electrically connected to apply a suitable electrical stimulus (e.g., a CV-type electrical stimulus) to contact 6, semiconductor wafer or sample 10, or both when semiconductor wafer or sample 10 is received on chuck 4 and conductive surface 20 of contact 6 is in contact with topside 16, topside 22, when present, or beveled surface 24.

A measurement means 32 can be electrically connected for measuring the response of semiconductor wafer or sample 10 to the test stimulus applied by the means for applying electrical stimulus 30 and for processing the measured response in any suitable and/or desirable manner. A display 33, or any other suitable output means, can also be provided to enable measurement means 32 to output in a human perceivable form the results of any processing performed by measurement means 32 on the measured response of semiconductor wafer or sample 10. Desirably, chuck 4 is connected to a reference ground 34. However, this is not to be construed as limiting the invention since chuck 4 alternatively can be connected to an AC or DC reference bias (not shown).

The present invention will now be described with reference to semiconductor wafer or sample 10 having dielectric layer 14 overlaying substrate 12. However, this is not to be construed as limiting the invention.

With reference to Fig. 2 and with continuing reference to Fig. 1, at a suitable time, a desired portion of semiconductor wafer or sample 10 is subject to lapping or grinding at a known small angle 50. The lapping or grinding of semiconductor wafer or sample 10 can be accomplished before or after semiconductor wafer or sample 10 is mounted on chuck 4. As shown in Fig. 1, the lapping or grinding of semiconductor wafer or sample 10 removes a portion of dielectric layer 14 and a wedge shaped portion of substrate 12 adjacent topside 16 thereby forming beveled surface 24 of substrate 12. Desirably, one or both of beveled surface 24 of substrate 12 and/or conductive surface 20 of contact 6 is a smooth, polished surface that maximizes contact between conductive surface 20 and beveled surface 24 when conductive surface 20 is pressed into contact with beveled surface 24.

At a suitable time, a plurality of CV-type measurements are made at a plurality of points laterally, desirably perpendicular, to a bevel edge 36 formed by the intersection of beveled surface 24 and topside 22 of dielectric layer 14. Each CV-type measurement is made by moving or pressing conductive surface 20 of contact 6 into contact with topside 22 of dielectric layer 14 or beveled surface 24 of substrate 12, whereupon a temporary capacitor is formed by the relationship of surface 20 in contact with topside 22 or beveled surface 24, and then applying a CV-type electrical stimulus to contact 6, semiconductor wafer or sample 10, or both. Fig. 2 shows a plurality of locations 38-1, 38-2, . . ., 38-7 where CV-type measurements can be made via conductive surface 20 of probe 6 in contact with topside 22 of dielectric layer 14 or beveled surface 24 of substrate 12. Each location 38 represents the contact area ($A_c$) between conductive surface 20 and topside 22 or beveled surface 24 when conductive surface 20 is in contact therewith.

An exemplary CV-type electrical stimulus includes sweeping a DC voltage, having an AC voltage superimposed thereon, from a first, starting voltage where substrate 12 underlying conductive surface 20 is, desirably, in inversion and a minimum capacitance ($C_{MIN}$) is measured, to a second, ending voltage where substrate 12 underlying conductive surface 20 is, desirably, in accumulation and a maximum capacitance ($C_{MAX}$) is measured.

An exemplary CV plot illustrating the sweep of the DC voltage between a first, starting voltage and a second, ending voltage and the corresponding change in capacitance from $C_{MIN}$ to $C_{MAX}$ is shown in Fig. 3. A CV-type electrical stimulus where the DC voltage is swept from a first, starting voltage to a second, ending voltage is more desirable since it can be detected when semiconductor substrate 12 underlying conductive surface 20 enters accumulation whereupon an optimal value for $C_{MAX}$ can be acquired.

Once values of $C_{MIN}$ and $C_{MAX}$ for each test location 38 has been acquired or measured, the near surface electrically active dopant density ($N_{SURF}$) of semiconductor wafer 10 can be determined for said location 38 utilizing the corresponding acquired values of $C_{MIN}$ and $C_{MAX}$ and the following equation EQ 1 which is solved iteratively to determine the corresponding value for $N_{SURF}$.

$$C_S = \sqrt{\frac{q^2 K_s \varepsilon_0 N_{SURF}}{2kT\{2|U_F| - 1 + \ln[1.15(|U_F| - 1)]\}}} \qquad \text{(EQ1)}$$

where

$$C_S = A_c \left[\frac{1}{C_{MIN}} - \frac{1}{C_{MAX}}\right]^{-1};$$

$A_c$ = the contact area between conductive surface 20 and the corresponding portion of topside 22 or beveled surface 24 at said location 38 when conductive surface 20 is in contact therewith;

$C_{MIN}$ = minimum measured capacitance;

$C_{MAX}$ = maximum measured capacitance;

$$U_F = \frac{q\phi_F}{kT};$$

$$\phi_F = \left(\frac{kT}{q}\right)\ln\left(\frac{N_{SURF}}{n_i}\right);$$

$$n_i = (3.87 e^{16})\left(T^{3/2}\right)^{\left(-E_g - \Delta E_g/2kT\right)};$$

$E_g$ = Energy Gap of the Semiconductor Wafer Substrate (1.124$eV$ at 300°K for Si);

$$\Delta E_g = (0.0225eV)\left[\frac{N_{SURF}}{10^{18}}\right]^{\frac{1}{2}};$$

$q$ = 1.6021×10$^{19}$ $Coulomb$;

$K_s$ = Dielectric Constant of the Material of the Substrate of the Semiconductor Wafer;

$\varepsilon_0$ = permittivity of free space ($8.854 \times 10^{14} F/cm$);

$k$ = Boltzmann's constant $8.617 \times 10^{-5} eV/T$; and

$T$ = temperature in degrees Kelvin.

With reference to Fig. 4 and with continuing reference to Figs. 1-3, a plot 40 (shown in dashed line) of $N_{SURF}$ versus depth can be formed from the value of $N_{SURF}$ determined at each test location 38. Plot 40 can then be compared to a reference plot 42 of $N_{SURF}$ versus depth determined theoretically or empirically utilizing a reference semiconductor wafer (not shown). Based on the degree of correlation between plot 40 and reference plot 42, it can be determined whether the near surface dopant density of the semiconductor wafer or sample 10 under test, and hence the efficacy of the ion doping of substrate 12, is within acceptable tolerance.

With reference to Figs. 2 and 4, the depth of each test location is a depth from the original location of topside 22 of dielectric layer 14. Specifically, for each test location 38-3 to 38-7, the depth of the test location 38 is the trigonometric sine of angle 50 multiplied by a distance 52 (measured parallel to topside 22 of dielectric layer 14) between bevel edge 36 and the center of the contact between conductive surface 20 and beveled surface 24. Thus, for example, the depth of test location 38-3 is a distance 52-3 multiplied by the trigonometric sine of angle 50; the depth of test location 38-4 is a distance 52-4 multiplied by the trigonometric sine of angle 50; and so forth.

In Fig. 2, test locations 38-1 and 38-2 are on topside 22 of dielectric layer 14. Therefore, in plot 40 shown in Fig. 4, test locations 38-1 and 38-2 are shown at the same depth.

The invention has been described with reference to the preferred embodiment. Obvious modifications and alterations will occur to others upon reading and understanding the preceding detailed description. For example, the number of test locations 38 shown in Fig. 2 is not to be construed as limiting the invention since it is envisioned that CV-type measurements can be taken at more or less test locations 38 if desired. Moreover, while beveled surface 24 is shown in Fig. 1 as not having a dielectric layer, a native oxide or dielectric (not shown) typically forms on beveled surface 24. This native oxide facilitates the acquisition of CV-type measurements on beveled surface 24. It is intended that the invention be construed as including all such modifications and alterations insofar as they come within the scope of the appended claims or the equivalents thereof.

## Claims

1.  A method of determining that a semiconductor wafer or sample has a desirable density of electrically active dopant, the method comprising:

    (a) providing a semiconductor wafer or sample having on a first side thereof a topside and a beveled surface positioned at an acute angle with respect to an imaginary extension of the topside above the beveled surface and on a second, opposite side thereof a backside, the intersection of the topside and the beveled surface defining a bevel edge;
    (b) positioning the semiconductor wafer or sample between a chuck and a contact with the backside of the semiconductor wafer or sample resting on the chuck;
    (c) causing the contact to press into contact with the topside and the beveled surface at a plurality of discrete points that run transverse to the bevel edge;
    (d) at each point in step (c), determining minimum and maximum capacitances of a capacitor formed when the contact is pressed into contact with the topside or the beveled surface;
    (e) determining as a function of the minimum and maximum capacitances determined for each point in step (d), a density of electrically active dopant in the semiconductor wafer or sample adjacent said point; and
    (f) determining that the electrically active dopant density of the semiconductor wafer or sample is within a predetermined tolerance based on a comparison of a first relationship of electrically active dopant densities determined in step (e) versus depths from the topside to a second relationship of electrically active dopant densities versus depths determined theoretically or empirically from a reference semiconductor wafer or sample.

2.  The method of claim 1, wherein in step (f), each relationship is a plot or curve of electrically active dopant density versus depth from the topside.

3.  The method of claim 1, wherein:

    the depth of each point on the topside is zero; and

the depth of each point on the beveled surface is the sine of the acute angle times a shortest distance between said point and the bevel edge when viewed normal to the topside.

4. The method of claim 1, wherein, when viewed normal to the topside, the plurality of points run perpendicular to the bevel edge.

5. The method of claim 1, wherein in step (c), the contact contacts the topside at least one time and the contact contacts the beveled surface at least one time.

6. The method of claim 1, wherein the portion of the contact that presses into contact with the topside and the beveled surface is at least partially spherical.

7. The method of claim 1, wherein in step (e), the density of electrically active dopant at each point is determined from the following equation:

$$C_S = \sqrt{\frac{q^2 K_s \varepsilon_0 N_{SURF}}{2kT\{2|U_F| - 1 + \ln[1.15(|U_F| - 1)]\}}}$$

where

$$C_S = A_c \left[ \frac{1}{C_{MIN}} - \frac{1}{C_{MAX}} \right]^{-1};$$

$A_c$ = the contact area between the contact and the corresponding portion of the topside or the beveled surface when the contact is pressed into contact therewith at said point;
$C_{MIN}$ = minimum measured capacitance;
$C_{MAX}$ = maximum measured capacitance;

$$U_F = \frac{q\phi_F}{kT};$$

$$\phi_F = \left( \frac{kT}{q} \right) \ln\left( \frac{N_{SURF}}{n_i} \right);$$

$$n_i = (3.87 e^{16})\left( T^{3/2} \right)^{\left( -E_g - \Delta E_g/2kT \right)};$$

$E_g$ = Energy Gap of the Semiconductor Wafer Substrate ($1.124eV$ at 300°K for Si);

$$\Delta E_g = (0.0225eV)\left[ \frac{N_{SURF}}{10^{18}} \right]^{\frac{1}{2}};$$

$q$ = 1.6021×10$^{19}$ *Coulomb*;

$K_s$ =Dielectric Constant of the Material of the Substrate of the Semiconductor Wafer;

$\varepsilon_0$ = permittivity of free space (8.854×10$^{14}$ *F/cm*);

$k$ = Boltzmann's constant 8.617×10$^{-5}$ *eV/T*; and

$T$ = temperature in degrees Kelvin.

8.  The method of claim 1, wherein the topside is either the topside of the semiconducting material of the semiconductor wafer or sample or the topside of a dielectric layer overlaying the semiconducting material of the semiconductor wafer or sample.

9.  A method of determining that a semiconductor wafer or sample has a desirable density of electrically active dopant, the method comprising:

    (a) providing a semiconductor wafer or sample having on a first side thereof a topside surface and a beveled surface formed by the removal of a portion of the topside surface thereabove, the beveled surface extending at an acute angle relative to the removed topside surface, the intersection of the topside surface and the beveled surface defining a bevel edge, the semiconductor wafer or sample having on a second, opposite side thereof a backside;

    (b) determining at each of a plurality of discrete points along the topside surface and the beveled surface minimum and maximum capacitances of a capacitor formed at said point that is comprised of the semiconducting material forming the semiconductor wafer or sample;

    (c) determining as a function of the minimum and maximum capacitances determined for each point of step (b), a density of electrically active dopant in the semiconductor wafer or sample at or adjacent said point; and

    (d) determining that the electrically active dopant density of the semiconductor wafer or sample is within a predetermined tolerance based on a comparison of a first relationship of electrically active dopant densities determined in step (c) versus depths from the topside surface to a second relationship of electrically active dopant densities versus depths determined theoretically or empirically from a reference semiconductor wafer or sample.

10.  The method of claim 9, wherein in step (d), each relationship is comprised of a set of data points of electrically active dopant density versus depth from the topside surface.

11.  The method of claim 10, wherein in step (d), each relationship is further comprised of a curve fitted to the corresponding set of data points.

12.  The method of claim 9, wherein:

    the plurality of points run transverse to the bevel edge when viewed normal to the topside surface;

    at least one point is on the topside surface;

    at least one point is on the beveled surface;

    the depth of each point on the topside surface is zero; and

    the depth of each point on the beveled surface is the sine of the acute angle times a shortest distance between said point and the bevel edge.

13.  The method of claim 9, wherein the minimum and maximum capacitances at each point are determined via a contact having at least a partially spherical surface pressed into contact with the topside surface or the beveled surface at said point.

14.  The method of claim 13, wherein the minimum and maximum capacitances at each point are determined via a CV-type electrical stimulus applied between said at least partially spherical surface and the semiconducting material of the semiconductor wafer or sample.

15.  The method of claim 9, wherein the density of electrically active dopant at each point is determined from the following equation:

$$C_S = \sqrt{\frac{q^2 K_s \varepsilon_0 N_{SURF}}{2kT\{2|U_F| - 1 + \ln[1.15(|U_F| - 1)]\}}}$$

where

$$C_S = A_c \left[ \frac{1}{C_{MIN}} - \frac{1}{C_{MAX}} \right]^{-1};$$

$A_c$ = an area associated with the capacitor formed at said point;
$C_{MIN}$ = minimum measured capacitance;
$C_{MAX}$ = maximum measured capacitance;

$$U_F = \frac{q\phi_F}{kT};$$

$$\phi_F = \left(\frac{kT}{q}\right)\ln\left(\frac{N_{SURF}}{n_i}\right);$$

$$n_i = \left(3.87\,e^{16}\right)\left(T^{3/2}\right)^{\left(-E_g - \Delta E_g / 2kT\right)};$$

$E_g$ = Energy Gap of the Semiconductor Wafer Substrate (1.124$eV$ at 300°K for Si);

$$\Delta E_g = \left(0.0225eV\right)\left[\frac{N_{SURF}}{10^{18}}\right]^{\frac{1}{2}};$$

$q$ = 1.6021$\times 10^{19}$ *Coulomb*;
$K_s$ = Dielectric Constant of the Material of the Substrate of the Semiconductor Wafer;
$\varepsilon_0$ = permittivity of free space (8.854$\times 10^{14}$ *F/cm*);
$k$ = Boltzmann's constant 8.617$\times 10^{-5}$ *eV/T*; and
$T$ = temperature in degrees Kelvin.

16. A method of determining that a semiconductor wafer or sample has a desirable density of electrically active dopant, the method comprising:

(a) determining minimum and maximum capacitances of a capacitor comprised of the semiconducting material forming a semiconductor wafer or sample at a first point on a topside surface of the semiconductor wafer or sample;
(b) determining minimum and maximum capacitances of a capacitor comprised of the semiconducting material forming the semiconductor wafer or sample at a second point on a beveled surface of the semiconductor wafer or sample, the beveled surface being formed by the removal of a portion of the topside surface thereabove; and
(c) determining that the electrically active dopant density of the semiconductor wafer or sample is within a predetermined tolerance as a function of the minimum and maximum capacitances determined for each said point and the depth on or from the topside surface where each said point resides.

**17.** The method of claim 16, wherein:

the depth of the first point is zero; and
the depth of the second point is the sine of an acute angle between the beveled surface and the removed topside surface thereabove times a shortest distance, as view normal to the topside surface, between said second point and an intersection of the beveled surface and the topside surface.

**18.** The method of claim 16, wherein step (c) further includes determining a set of data points of electrically active dopant density versus depth from the topside surface.

**19.** The method of claim 16, wherein the minimum and maximum capacitances at each point are determined via a contact having at least a partially spherical surface pressed into contact with the surface at said point.

**20.** The method of claim 19, wherein the capacitances at each point are determined via a CV-type electrical stimulus applied between said at least partially spherical surface and the semiconducting material of the semiconductor wafer or sample.

FIG. I

FIG. 2

FIG. 3

FIG. 4

**EP 1 863 078 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 60793565 B